(19)

Europäisches Patentamt
European Patent Office
Office européen des brevets

(11)  **EP 1 421 445 B1**

(12)  # EUROPÄISCHE PATENTSCHRIFT

(45) Veröffentlichungstag und Bekanntmachung des Hinweises auf die Patenterteilung:
**09.10.2013  Patentblatt 2013/41**

(21) Anmeldenummer: **02758411.9**

(22) Anmeldetag: **30.07.2002**

(51) Int Cl.:
**G03F 1/36** *(2012.01)*

(86) Internationale Anmeldenummer:
**PCT/EP2002/008482**

(87) Internationale Veröffentlichungsnummer:
**WO 2003/021353 (13.03.2003 Gazette 2003/11)**

(54) **PHOTOLITHOGRAPHISCHE MASKE**

PHOTOLITHOGRAPHIC MASK

MASQUE PHOTOLITHOGRAPHIQUE

(84) Benannte Vertragsstaaten:
**DE**

(30) Priorität: **31.08.2001  DE 10142588**
**29.01.2002  DE 10203358**

(43) Veröffentlichungstag der Anmeldung:
**26.05.2004  Patentblatt 2004/22**

(73) Patentinhaber: **Qimonda AG i.IN.**
**81739 München (DE)**
Benannte Vertragsstaaten:
**DE**

(72) Erfinder:
• **BAUCH, Lothar**
**01259 Dresden (DE)**

• **KUNKEL, Gerhard**
**01445 Radebeul (DE)**
• **SACHSE, Hermann**
**01309 Dresden (DE)**
• **WURZER, Helmut**
**01099 Dresden (DE)**

(74) Vertreter: **Zimmermann & Partner et al**
**Josephspitalstr. 15**
**80331 München (DE)**

(56) Entgegenhaltungen:
**EP-A- 0 770 926     EP-A- 1 241 525**
**US-A- 5 229 230     US-A- 5 821 014**
**US-A- 5 900 349**

**Beschreibung**

Die vorliegende Erfindung betrifft photolithographische Masken. Die vorliegende Erfindung betrifft insbesondere photolithographische Masken zur Strukturierung von strahlungsempfindlichen Resistschichten auf Halbleitersubstraten zur Herstellung von hochintegrierten Halbleiterbauelementen.

Im Zuge der immer kleiner werdenden Strukturabmessungen zur Erzeugung von hochintegrierten Halbleiterbauelementen wird eine maßgetreue photolithographische Übertragung von Maskenstrukturen auf strahlungsempfindliche Resistschichten immer wichtiger. Inzwischen werden Halbleiterbauelemente mit Strukturlinienbreiten von 180 nm und weniger zur kommerziellen Verwendung in großem Volumen hergestellt, so daß die Anforderungen an die strukturierenden Prozeßschritte höchsten Standards genügen müssen. Die photolithographische Übertragung von Maskenstrukturen auf strahlungsempfindliche Resistschichten ist dabei eine der herausragenden Techniken zur Strukturierung von Schichten auf Halbleiterbauelementen.

Die photolithographische Übertragung von Maskenstrukturen auf eine strahlungsempfindliche Resistschicht erfolgt dabei in mehreren Schritten. Nach der Justage der Maske über dem mit der strahlungsempfindlichen Resistschicht überdeckten Substrat folgt die Belichtung der strahlungsempfindlichen Resistschicht durch die Maske zur Selektion des zu entfernenden (oder stehenzulassenden) Resistschichtmaterials. Die Belichtung der strahlungsempfindlichen Resistschicht kann dabei im Schattenrißverfahren erfolgen, wobei die Maske auf der Resistschicht aufliegt (Kontakt- Belichtung), oder dicht über der Resistschicht aufgebracht ist (Proximity-Belichtung) . Für höchstauflösende Strukturierung wird die Belichtung dagegen über eine sogenannte Projektionsbelichtung durchgeführt. Das durch die Maske durchgetretene Licht wird dabei in einem Projektionsobjektiv auf die Resistschicht fokussiert, wobei das Projektionsobjektiv möglichst viele durch die Maskenstruktur erzeugte höhere Beugungsordnungen abbildet. Durch dieses Abbildungsverfahren kann eine minimale übertragbare Strukturlinienbreite, $b_{min}$, von

$$(1) \qquad b_{min} = k_1 \ (\lambda \ /NA)$$

von der Maske auf die Resistschicht abgebildet werden; $\lambda$ ist in diesem Fall die Wellenlänge, mit der belichtet wird, und NA die numerische Apertur, d.h. im wesentlichen das Verhältnis des halben Objektivfensterdurchmessers zum Abstand zwischen Wafer und Objektiv ; Im Bereich der Auflösungsgrenze nimmt die Proportionalitätskonstante $k_1$ Werte $k_1 < 0, 5$ an, und es müssen besondere Maßnahmen zur Kontrastverstärkung getroffen werden, um ein ausreichendes Prozeßfenster in der Lithographie zu gewährleisten.

Wenn die strahlungsempfindliche Resistschicht eine positive Resistschicht ist, so bewirkt die Belichtung an den belichteten Stellen eine chemische Veränderung des Resistschichtmaterials, das bei der Entwicklung aus der Resistschicht herausgespült werden kann. Ist die strahlungsempfindliche Resistschicht dagegen eine negative Resistschicht, so wird bei der Entwicklung das nicht belichtete Material herausgspült. Um die gleiche Struktur wie bei dem positiven Resist zu erhalten, muß die Maske im wesentlichen komplementär zur Maske für den positiven Resist strukturiert sein.

Nach der Belichtung und weiteren Schritten, wie der Initialisierung der sogenannten "PAG" (photo acid generator) dem sogenannten "PEB" (post exposure bake) sowie der Einstellung des Diffusionsgradienten und damit des  Resistprofils, folgt die Entwicklung der Resistschicht durch Besprühen oder Aufschleudern mit Entwicklerflüssigkeit, die das markierte Resistschichtmaterial selektiv ablöst (oder selektiv resistent läßt). Nach der Trocknung des Substrats erhält man schließlich den strukturierten Resist, der i.A. zum Abschluß einem Temperaturschritt zur Aushärtung unterzogen wird.

Die minimale Strukturlinienbreite auf der Maske, die nach der Erzeugung der Resiststruktur tatsächlich erzeugt wird, ist am Ende aus mehreren Gründen größer als aus (1) errechnet. Zum einen hat die Resistschicht eine endliche Dicke, so daß die Abbildung leicht verschmiert; weiterhin wirkt der Entwickler isotrop, so daß bei der Entwicklung der Resistschicht der Resist auch in lateraler Richtung abgetragen wird. Die minimale Strukturlinienbreite auf der Maske, die für die Erzeugung einer Resistschichtstruktur auf einem Halbleitersubstrat benötigt wird, hängt daher von vielen Parametern ab und wird für jeden Strukturierungsprozeß einzeln bestimmt.

Die Maske besteht z.B. aus einem unstrukturierten Quarzglassubstrat, das auch im UV-Bereich lichtdurchlässig ist und auf dem eine dünne lichtundurchlässige Schicht, meist aus Schwarzchrom, aufgebracht ist. Die Schwarzchromschicht erzeugt zusammen mit den durchlässigen Bereichen die Maskenstruktur, die auf die Resistschicht abgebildet wird. Die Schwarzchromschicht erzeugt dabei die abgedunkelten Bereiche auf der Resistschicht während der lichtdurchlässige Bereich die belichteten Bereiche auf dem Resist erzeugt. Ist der Resist positiv, so wird die Abtragungsrate des Resists im Entwickler in den belichteten Bereichen im Vergleich zu den unbelichteten Bereichen drastisch erhöht und durch den Entwicklungsschritt abgetragen. Ist der Resist negativ, so vernetzt der Resist in den belichteten Bereichen, so daß bei der Entwicklung überwiegend die unbelichteten Bereiche abgetragen werden. Für eine maßgetreue Strukturübertragung  ist es weiterhin wichtig, eine über den zu belichtenden Bereich homogene Belichtungsdosis zu gewährleisten.

Zur Beeinträchtigung der Maßtreue können verschiedene Effekte beitragen. Zum einen verursacht der endliche Resistkontrast y, der ein Maß für den Resistabtragungsgradienten bei gegebener Belichtungsdosis ist, eine Verrundung von ursprünglich eckigen Maskenstrukturen. Weiterhin können Interferenzeffekte, Beugungseffekte und Streulicht, die an Strukturelementen der Maske, der Resistschicht und/oder der vorstrukturierten Substratoberfläche entstehen, dazu führen, daß die effektive Belichtungsdosis in den Resistschichtbereichen nicht homogen ist.

Insbesondere die Beugungs- und Interferenzeffekte von nahe beieinander liegenden Maskenstrukturen, sogenannte "Proximity Effekte", können zu einer deutlichen Beeinträchtigung der erzielbaren Maßtreue führen. Dabei sind die Proximity Effekte um so ausgeprägter je näher die Strukturen beieinander liegen. Dies hat beispielsweise zur Folge, daß Strukturen, die eigentlich die gleiche Größe aufweisen sollen, in Abhängigkeit ihrer jeweiligen Umgebung in unterschiedlicher Weise in die Resistschicht abgebildet werden. Dieser Unterschied zeigt sich besonders deutlich zwischen Strukturen, die sehr dicht angeordnet sind, und Strukturen, die ohne benachbarte Strukturen weitgehend isoliert sind.

Um diesen Unterschied weitgehend auszugleichen, werden üblicherweise Hilfsstrukturen, sogenannte "Scattering Bars" oder "SRAF = sub resolution assist features", verwendet, die in der Nähe von isolierten Strukturen angeordnet werden. Dementsprechend besitzt eine eigentlich isolierte Struktur nun eine Umgebung, die weitgehend der Umgebung von dicht angeordneten Strukturen entspricht, so daß sich im wesentlichen die gleichen Abbildungseigenschaften ergeben. Dabei sind diese Hilfsstrukturen auf der Maske so ausgebildet, daß sie selbst nicht in die Resistschicht abgebildet werden, und sie werden jeweils parallel zu den Kanten der eigentlichen Strukturen auf der Maske angeordnet. Hilfsstrukturen dieser Art sind beispielsweise in den US Patenten 5,242,770 und 5,821,014 beschrieben. Außerdem ist aus der EP 0770926 A ein Verfahren zur Bildung feiner Muster von Halbleiterbauelementen bekannt. Dabei werden Hilfslinien und Hilfszwischenräume unterhalb der Auflösungsgrenze der optischen Quelle zu einem Hauptmuster einer Maske hinzugefügt.

Die herkömmlichen Hilfsstrukturen sind insbesondere geeignet, die Abbildungseigenschaften von isolierten Strukturen zu verbessern. Im Layout einer Maske können jedoch durchaus Strukturen auftreten, die weder klar isoliert noch besonders dicht angeordnet sind. So ist es beispielsweise nicht immer möglich den Abstand zwischen zwei Gate-Bahnen so groß zu machen, daß jeweils ihre zugeordneten Hilfsstrukturen zwischen die Gate-Bahnen passen, bzw. die Gate-Bahnen so dicht zusammenzulegen, daß sie auch ohne Hilfsstrukturen ausreichend gute Abbildungseigenschaften aufweisen. Für diese Fälle wird in der Regel eine einzige Hilfsstruktur in die Mitte zwischen die beiden Gate-Bahnen plaziert. Diese Hilfsstruktur besitzt jedoch in der Regel nicht den optimalem Abstand zu den Gate-Bahnen und hat für viele Abstandsbereiche kaum mehr eine vergrößernde Wirkung auf das Fokus-Prozeßfenster in der Lithographie. Werden jedoch diese Abstandsbereiche im Design verboten, so hat dieses negative Auswirkungen auf den Designaufwand und die Chipgröße.

Der vorliegenden Erfindung liegt daher die Aufgabe zugrunde, eine photolithographische Maske bereitzustellen, welche die beschriebenen Probleme vermindert bzw. ganz vermeidet.

Diese Aufgabe wird von der erfindungsgemäßen photolithographischen Maske gemäß des unabhängigen Patentanspruchs 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird eine photolithographische Maske zur Belichtung von strahlungsempfindlichen Resistschichten auf Halbleitersubstraten bereitgestellt, wobei die Maske zumindest ein strahlungsdurchlässiges Substrat und zumindest eine strahlungsundurchlässige Schicht oder/und zumindest eine Halbtonschicht aufweist. Mittels der strahlungsundurchlässigen Schicht oder/und der Halbtonschicht sind Hauptstrukturen vorgesehen, wobei das Verhältnis von Länge zu Breite der Hauptstrukturen größer als 3 ist, und wobei die Hauptstrukturen so ausgebildet sind, daß das durch die Hauptstrukturen gebildete Muster bei einer Bestrahlung in die Resistschicht übertragen wird, und mittels der strahlungsundurchlässigen Schicht oder/und der Halbtonschicht sind Hilfsstrukturen vorgesehen, wobei die Hilfsstrukturen so ausgebildet sind, daß das durch die Hilfsstrukturen gebildete Muster bei einer Bestrahlung nicht in die Resistschicht übertragen wird.

Unter einer Halbtonschicht wird dabei eine zu einem gewissen Prozentsatz strahlungsdurchlässige Schicht verstanden, welche die Phase der durch sie hindurchtretenden Strahlung um einen vorgegebenen Betrag verschiebt. Je nach Anwendungsfall können die Haupt- bzw. Hilfsstrukturen aus Teilbereichen der strahlungsundurchlässigen Schicht bzw. der Halbtonschicht oder als Öffnungen in der strahlungsundurchlässigen Schicht bzw. der Halbtonschicht ausgebildet sein.

Die erfindungsgemäße photolithographische Maske ist dadurch gekennzeichnet, daß zwischen zwei unmittelbar benachbarten Hauptstrukturen, die zumindest im Bereich eines Teilstücks im wesentlichen parallel in eine erste Richtung ausgerichtet sind, zumindest zwei Hilfsstrukturen vorgesehen sind, die in eine zweite Richtung im wesentlichen senkrecht zu der ersten Richtung ausgerichtet sind.

Die Hauptstrukturen bzw. die Teilstücke, aus denen die Hauptstrukturen häufig zusammengesetzt sind, besitzen in der Regel eine Form, die entlang einer Richtung (Längsrichtung) eine deutlich größere Ausdehnung besitzt als in einer dazu senkrechten Richtung. Typischerweise weisen die Hauptstrukturen bzw. deren Teilstücke eine rechtecksähnliche Form auf, die deutlich länger als breit ist. Dementsprechend kann man sagen, daß die Hauptstrukturen bzw. die Teilstücke der Hauptstrukturen in eine Richtung, nämlich ihre Längsrichtung, ausgerichtet sind. Auch die Hilfsstrukturen besitzen in der Regel eine Form, die entlang einer Richtung (Längsrichtung) eine deutlich größere Ausdehnung besitzt als in einer dazu senkrechten Richtung. Dementsprechend sind auch die Hilfsstrukturen in eine Richtung, nämlich ihre Längsrichtung, ausgerichtet.

Nach dem Stand der Technik werden nun jeweils Hilfsstrukturen eingesetzt, die im wesentlichen parallel zu den Hauptstrukturen bzw. zu Teilstücken der Hauptstrukturen ausgerichtet sind. Wie bereits erläutert führt dies jedoch zu Schwierigkeiten insbesondere in den Fällen, bei denen die Hauptstrukturen einen Abstand aufweisen, der weder besonders groß (isolierte Hauptstrukturen) noch besonders klein ist (dicht angeordnete Hauptstrukturen).

Im Gegensatz dazu werden bei der erfindungsgemäßen photolithographischen Maske Hilfsstrukturen eingesetzt, die im wesentlichen senkrecht zu den Hauptstrukturen ausgerichtet sind. Die erfindungsgemäße photolithographischen Maske besitzt den Vorteil, daß nun auch Hauptstrukturen bzw. Kanten von Hauptstrukturen, deren Abbildungseigenschaften bisher nicht durch Hilfsstrukturen verbessert werden konnten, eine Verbesserung ihrer Abbildungseigenschaften erfahren, wodurch insbesondere das Prozeßfenster für den gesamten Lithographie-Prozeß verbessert wird.

Gemäß einer bevorzugten Ausführungsform der erfindungsgemäßen photolithographischen Maske weisen die Hilfsstrukturen eine rechteckige Form auf. Weiterhin ist es bevorzugt, wenn die Breite b der Hilfsstrukturen in dem Bereich $\lambda/(10\,NA) < b < \lambda/(3\,NA)$ liegt, wobei $\lambda$ die Wellenlänge der zur Bestrahlung der Maske bzw. der Resistschicht verwendeten Strahlung ist.

Gemäß einer weiteren bevorzugten Ausführungsform der erfindungsgemäßen photolithographischen Maske liegt der Abstand D der Hauptstrukturen in dem Bereich $\lambda/(2\,NA) < D < 3\lambda/NA$. Weiterhin ist es bevorzugt, wenn der Abstand x der Hilfsstrukturenden von den Hauptstrukturen in dem Bereich $\lambda/(5\,NA) < x < 2\lambda/(3\,NA)$ bzw. wenn der Abstand d der Hilfsstrukturenden im Bereich $\lambda/(3\,NA) < d < 3\lambda/(2\,NA)$ liegt.

Gemäß einer weiteren bevorzugten Ausführungsform der erfindungsgemäßen photolithographischen Maske sind zu einer Hauptstruktur, die zumindest im Bereich eines Teilstücks in eine erste Richtung ausgerichtet ist, zumindest vier, bevorzugt zumindest sechs, Hilfsstrukturen vorgesehen, die benachbart zum dem Teilstück in eine zweite Richtung im wesentlichen senkrecht zu der ersten Richtung ausgerichtet sind.

Gemäß einer weiteren bevorzugten Ausführungsform der erfindungsgemäßen photolithographischen Maske ist das Verhältnis von Länge zu Breite der Hauptstrukturen größer als 2, bevorzugt größer als 3.

Die Erfindung wird nachfolgend anhand von Figuren der Zeichnung näher dargestellt. Es zeigen:

Fig. 1     eine photolithographische Maske gemäß einer ersten Ausführungsform der vorliegenden Erfindung,

Fig. 2     eine photolithographische Maske gemäß einer weiteren Ausführungsform der vorliegenden Erfindung,

Fig. 3     ein Diagramm, das die Abhängigkeit der Bestrahlungsstärke von der Defokussierung der Bestrahlung für die in Fig. 2 gezeigte Photomaske wiedergibt,

Fig. 4     eine photolithographische Maske nach dem Stand der Technik,

Fig. 5     ein Diagramm, das die Abhängigkeit der Bestrahlungsstärke von der Defokussierung der Bestrahlung für die in Fig. 4 gezeigte Photomaske wiedergibt,

Fig. 6     eine weitere photolithographische Maske nach dem Stand der Technik,

Fig. 7     ein Diagramm, das die Abhängigkeit der Bestrahlungsstärke von der Defokussierung der Bestrahlung für die in Fig. 6 gezeigte Photomaske wiedergibt; und

Fig. 8     eine photolithographische Maske gemäß einer weiteren Ausführungsform der vorliegenden Erfindung.

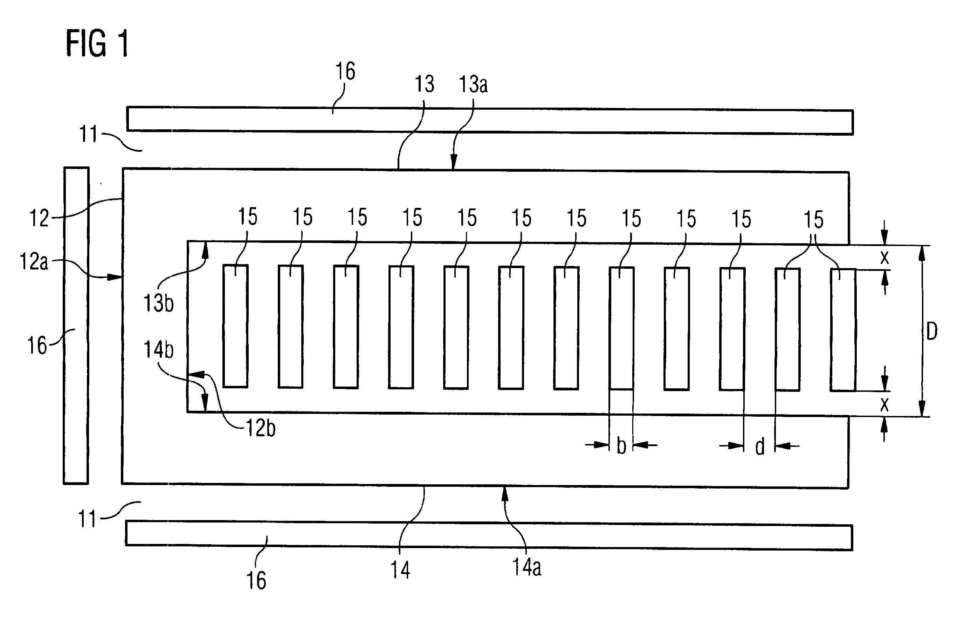

Fig. 1 zeigt eine photolithographische Maske gemäß einer ersten Ausführungsform der vorliegenden Erfindung in einer Aufsicht. Die in Fig. 1 gezeigte Ausführungsform weist ein strahlungsdurchlässiges Substrat (11), beispielsweise aus Quarzglas, und strahlungsundurchlässige Strukturen (12, 13, 14, 15 und 16) auf, welche auf das Substrat aufgebracht sind. Als Material für die strahlungsundurchlässige Schicht kann beispielsweise Schwarzchrom eingesetzt werden.

Die Maske besitzt eine Gruppe von 3 Hauptstrukturen 12, 13 bzw. 14, die weder vollständig isoliert und noch sehr dicht aneinander angeordnet sind. Die Hauptstrukturen 12, 13 bzw. 14 sind dabei jeweils als opake Bereiche auf der strahlungsundurchlässigen Schicht vorgesehen. Die Hauptstrukturen 12, 13, 14 sind dabei so ausgebildet, daß das durch die Hauptstrukturen 12, 13, 14 gebildete Muster bei einer Bestrahlung in die Resistschicht (nicht gezeigt) übertragen wird. Die Hauptstrukturen 12, 13, 14 definieren somit das zu übertragende Muster. Dabei können die Hauptstrukturen 12, 13, 14 als einzelne Hauptstrukturen oder als Teilstücke einer "großen", U-förmigen Hauptstruktur angesehen werden.

Die in Fig. 1 gezeigten Hauptstrukturen 12, 13, 14 stellen im wesentlichen isolierte Hauptstrukturen dar, welche zur Verbesserung ihrer Abbildungseigenschaften auf zusätzliche Hilfsstrukturen angewiesen sind. Benachbart zu den äußeren Kanten 12a, 13a, 14a sind daher die Hilfsstrukturen 16 angeordnet, die wie im Stand der Technik parallel zu den Hauptstrukturen 12, 13, 14 ausgerichtet sind. Die Hilfsstrukturen 16 weisen dabei eine rechteckige Form auf und sie sind derart ausgebildet, daß das durch die Hilfsstrukturen 16 gebildete Muster bei einer Bestrahlung nicht in die Resistschicht übertragen wird.

Die Hilfsstrukturen 16 verbessern insbesondere die Abbildungseigenschaften der äußeren Kanten 12a, 13a, 14a der Hauptstrukturen 12, 13, 14. Zur Verbesserung der Abbildungseigenschaften der inneren Kanten 12b, 13b, 14b der Hauptstrukturen 12, 13, 14 sind ebenfalls Hilfsstrukturen notwendig. Die Hauptstrukturen 12, 13, 14 sind jedoch so zueinander angeordnet, daß herkömmliche, parallel zu den Hauptstrukturen 12, 13, 14 angeordnete Hilfsstrukturen nicht verwendet werden können, da sich diese herkömmlichen Hilfsstrukturen gegenseitig stören würden. Insbesondere wenn der Abstand D zwischen den beiden Hauptstrukturen in dem Bereich $\lambda/(2\,NA) < D < 3\lambda/NA$ liegt, können keine parallelen Hilfsstrukturen, entsprechend den Hilfsstrukturen 16, eingesetzt werden.

Um trotz dieser Schwierigkeiten eine Verbesserung der Abbildungseigenschaften der inneren Kanten 12b, 13b, 14b der Hauptstrukturen 12, 13, 14 zu gewährleisten, sind der erfindungsgemäßen photolithographischen Maske Hilfsstrukturen 15 eingesetzt, die im wesentlichen senkrecht zu den Hauptstrukturen 13, 14 ausgerichtet sind. Die Hilfsstrukturen 15 sind ebenfalls rechteckig ausgebildet und symmetrisch zu den Hauptstrukturen 13, 14 zwischen den Hauptstrukturen 13, 14 angeordnet.

Der Abstand x der Hilfsstrukturen 15 von den Hauptstrukturen liegt in dem Bereich $\lambda/(5\,NA) < x < 2\lambda/(3\,NA)$ bzw. der Abstand d der Hilfsstrukturen liegt im Bereich $\lambda/(3\,NA) < d < 3\lambda/(2\,NA)$. Weiterhin liegt die Breite b der Hilfsstrukturen 15 in dem Bereich $\lambda/(10\,NA) < b < \lambda/(3\,NA)$, wobei $\lambda$ die Wellenlänge der zur Bestrahlung der Maske bzw. der Resistschicht verwendeten Strahlung ist. Dabei sind die genauen Längen, Abstände und Breiten der Hilfsstrukturen 15 von einer Vielzahl von Prozeßparametern wie beispielsweise dem verwendeten Photolack, Bestrahlungsdosis etc. abhängig, so daß diese Größen passend zu dem jeweiligen Lithographie-Prozeß eingestellt werden müssen.

Die erfindungsgemäße photolithographischen Maske besitzt den Vorteil, daß nun auch die Kanten 13b und 14b der Hauptstrukturen 13 und 14, deren Abbildungseigenschaften bisher nicht durch Hilfsstrukturen verbessert werden konnten, eine Verbesserung ihrer Abbildungseigenschaften erfahren, wodurch insbesondere das Prozeßfenster für den gesamten Lithographie-Prozeß verbessert wird.

Die unter Bezugnahme auf Fig. 1 beschriebene Ausführungsform der vorliegenden Erfindung betrifft eine Photomaske, die eine strahlungsundurchlässige Schicht, beispielsweise eine Schwarzchromschicht, aufweist. Im folgenden wird eine Ausführungsform der vorliegenden Erfindung beschrieben, die anstatt einer strahlungsundurchlässige Schicht eine Halbtonschicht, beispielsweise eine $MoSi_zO_xN_y$- Schicht, aufweist.

Dazu wird anstatt einer strahlungsundurchlässigen Schicht eine Halbtonschicht auf das Glassubstrat aufgebracht, wobei die Halbtonschicht zu einem gewissen Prozentsatz strahlungsdurchlässig (z.B. 3% bis 10% Strahlungstransmission) ist und die Phase der durch die Halbtonschicht hindurchtretenden Strahlung um einen vorgegebenen Betrag verschiebt. Anschließend wird diese Halbtonschicht entsprechend strukturiert, so daß Strukturen in der Schicht erzeugt werden, welche an das zu übertragendem Muster angepaßt sind. Wird die Maske nun bestrahlt, so kommt es an den Rändern der Strukturen zu einem Phasensprung (in der Regel 180°), wodurch sich die erzielbare Auflösung erhöhen läßt.

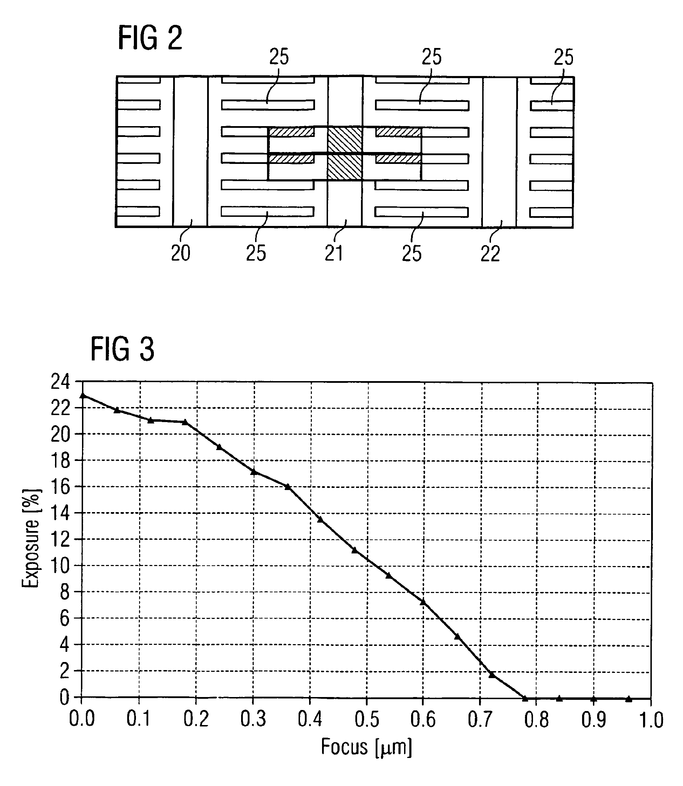

Fig. 2 zeigt in einer Aufsicht einen Ausschnitt aus einer erfindungsgemäßen Photomaske, wobei die Hauptstrukturen 20, 21 und 22 aus Halbtonmaterial gebildet sind. Die Dicke des Halbtonmaterials ist dabei so gewählt, daß an den Kanten der Hauptstrukturen 20, 21 und 22 beim Durchtritt der Strahlung jeweils ein Phasensprung von 180° gegenüber der Umgebung auftritt. Die Hauptstrukturen 20, 21 und 22 sind so ausgebildet, daß das durch die Hauptstrukturen 20, 21 und 22 gebildete Muster bei einer Bestrahlung in die Resistschicht (nicht gezeigt) übertragen wird. Die Hauptstrukturen 20, 21 und 22 definieren somit das zu übertragende Muster.

Die in Fig. 2 gezeigten Hauptstrukturen 20, 21 und 22 stellen wiederum im wesentlichen isolierte Hauptstrukturen dar, welche zur Verbesserung ihrer Abbildungseigenschaften auf zusätzliche Hilfsstrukturen angewiesen sind. Dementsprechend sind bei der erfindungsgemäßen photolithographischen Maske Hilfsstrukturen 25 aus Halbtonmaterial eingesetzt, die im wesentlichen senkrecht zu den Hauptstrukturen 20, 21 und 22 ausgerichtet sind. Die Dicke des Halbtonmaterials ist wiederum so gewählt, daß an den Kanten der Hilfsstrukturen 25 beim Durchtritt der Strahlung jeweils ein Phasensprung von 180° gegenüber der Umgebung auftritt. Die Hilfsstrukturen 25 sind ebenfalls rechteckig ausgebildet und symmetrisch zu den Hauptstrukturen 20, 21 und 22 zwischen den Hauptstrukturen 20, 21 und 22 angeordnet. Wiederum sind die Hilfsstrukturen 25 so ausgebildet sind, daß das durch die Hilfsstrukturen gebildete Muster bei einer Bestrahlung nicht in die Resistschicht übertragen wird.

Im vorliegenden Beispiel besitzen die Hauptstrukturen 20, 21 und 22 eine Breite von 200 nm, was bei einer Bestrahlung zu einer Struktur mit einer Breite 190 nm in der Resistschicht führt. Der Abstand zwischen den Hauptstrukturen beträgt 1000 nm. Die Hilfsstrukturen 25 besitzen eine Breite von 50 nm und sind in einem Abstand von 125 nm angeordnet. Dies zeigt, dass im Gegensatz zu herkömmlichen Photomasken bei einer erfindungsgemäßen Photomaske der sogenannte "Maskbias", also die Verbreiterung der Struktur auf der Maske gegenüber der Breite der Struktur in der Resistschicht deutlich verkleinert werden kann.

Fig. 3 zeigt ein Diagramm, das die Abhängigkeit der Bestrahlungsstärke von der Defokussierung der Bestrahlung wiedergibt. Der Bereich unterhalb der Kurve gibt dabei die Parameterkombinationen an, bei denen sich eine gute Abbildung der Hauptstrukturen erzielen läßt. Der Bereich unterhalb der Kurve ist somit ein Maß für das Prozeßfenster, innerhalb dessen die Bestrahlungsparameter verändert werden dürfen. Man erkennt, daß die Defokussierung der Bestrahlung über einen weiten Bereich variiert werden kann und trotzdem eine gute Abbildung der Hauptstrukturen gewährleistet ist.

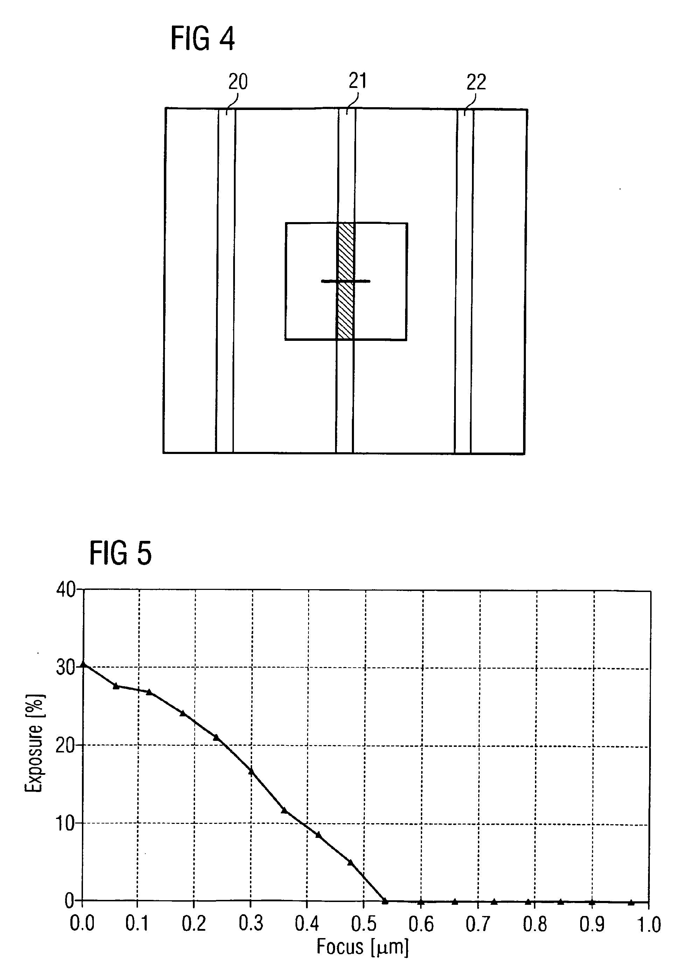

Fig. 4 zeigt zum Vergleich eine Photomaske nach dem Stand der Technik, die nur die Hauptstrukturen 20, 21 und 22 aber keine Hilfsstrukturen aufweist. Dabei beträgt die Breite der Hauptstrukturen 20, 21 und 22 250 nm, um in der Resistschicht Bahnen mit einer Breite von 190 nm zu erzeugen. Dementsprechend wird im Vergleich zu der erfindungsgemäßen Photomaske bei der herkömmlichen Photomaske ein deutlich größerer Maskbias benötigt. Wie aus Fig. 5 ersichtlich ergibt sich für die herkömmliche Photomaske auch ein deutlich verkleinertes Prozeßfenster, was in der Praxis dazu führt, daß die Hauptstrukturen 20, 21 und 22 nicht reproduzierbar in eine Resistschicht übertragen werden können.

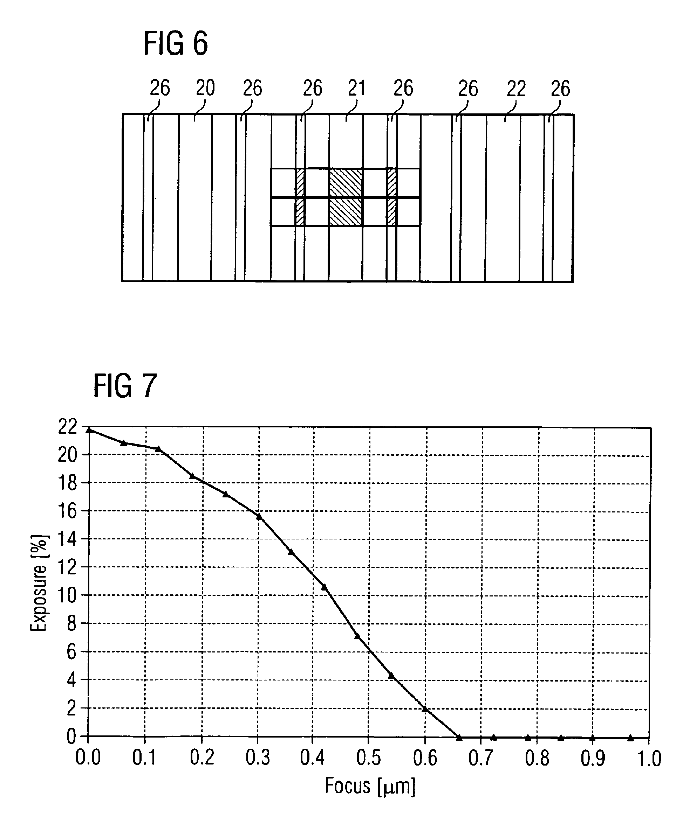

Fig. 6 zeigt ebenfalls zum Vergleich eine Photomaske nach dem Stand der Technik, welche die Hauptstrukturen 20, 21 und 22 und herkömmliche, parallele Hilfsstrukturen 26 aufweist. Dabei beträgt die Breite der Hauptstrukturen 20, 21 und 22 240 nm, um in der Resistschicht Bahnen mit einer Breite von 190 nm zu erzeugen. Dementsprechend wird im Vergleich zu der erfindungsgemäßen Photomaske auch bei dieser herkömmlichen Photomaske ein deutlich größerer Maskbias benötigt.

Obwohl bei diesem Beispiel die Hauptstrukturen einen Abstand (1000 nm) aufweisen, bei dem herkömmliche parallele Hilfstrukturen noch eingesetzt werden können, ergibt sich, wie aus Fig. 7 ersichtlich, auch für diese Photomaske eine deutlich verkleinertes Prozeßfenster.

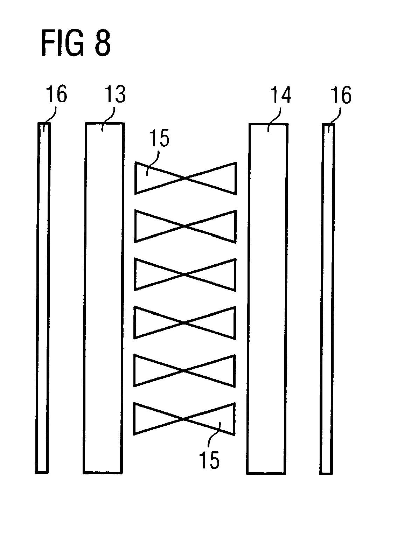

Fig. 8 zeigt eine photolithographische Maske gemäß einer weiteren Ausführungsform der vorliegenden Erfindung. Im Gegensatz zu den bisher beschriebenen Ausführungsformen der erfindungsgemäßen photolithographischen Maske die Hilfsstrukturen 15 nicht als Rechtecke ausgebildet sondern sie setzen sich aus Dreiecken zusammen. Die Hilfsstrukturen 15 besitzen wiederum den Vorteil, daß nun auch die Kanten 13b und 14b der Hauptstrukturen 13 und 14, deren Abbildungseigenschaften bisher nicht durch Hilfsstrukturen verbessert werden konnten, eine Verbesserung ihrer Abbildungseigenschaften erfahren, wodurch insbesondere das Prozeßfenster für den gesamten Lithographie-Prozeß verbessert wird.

## Patentansprüche

1. Photolithographische Maske zur Belichtung von strahlungsempfindlichen Resistschichten auf Halbleitersubstraten, wobei die Maske

   - zumindest ein strahlungsdurchlässiges Substrat und zumindest eine Halbtonschicht aufweist, wobei die Halbtonschicht eine zu einem gewissen Prozentsatz strahlungsdurchlässige Schicht ist, die die Phase der durch sie hindurchtretenden Strahlung um einen vorgegeben Betrag verschiebt,
   - mittels der Halbtonschicht Hauptstrukturen (12, 13, 14, 20, 21, 22) vorgesehen sind, wobei das Verhältnis von Länge zu Breite der Hauptstrukturen (12, 13, 14, 20, 21, 22) größer als 3 ist, und wobei die Hauptstrukturen (12, 13, 14, 20, 21, 22) so ausgebildet sind, daß das durch die Hauptstrukturen (12, 13, 14, 20, 21, 22) gebildete Muster bei einer Bestrahlung in die Resistschicht übertragen wird, und
   - mittels der Halbtonschicht Hilfsstrukturen (15, 16, 25, 26) vorgesehen sind, wobei die Hilfsstrukturen (15, 16, 25, 26) so ausgebildet sind, daß das durch die Hilfsstrukturen (15, 16, 25, 26) gebildete Muster bei einer Bestrahlung nicht in die Resistschicht übertragen wird, wobei

   zwischen zwei unmittelbar benachbarten Hauptstrukturen (13, 14, 20, 21, 22), die zumindest im Bereich eines Teilstücks im wesentlichen parallel in eine erste Richtung ausgerichtet sind, zumindest zwei Hilfsstrukturen (15, 25) vorgesehen sind, die in eine zweite Richtung im wesentlichen senkrecht zu der ersten Richtung ausgerichtet sind.

2. Photolithographische Maske nach Anspruch 1, **dadurch gekennzeichnet, daß** die Hilfsstrukturen(15, 25) eine rechteckige Form aufweisen.

3. Photolithographische Maske nach Anspruch 1, **dadurch gekennzeichnet, daß** die Hilfsstrukturen(15) aus dreieckige<u>n</u> Formen aufgebaut sind.

4. Photolithographische Maske nach einem der vorhergehenden Ansprüche,
   **dadurch gekennzeichnet, daß**
   die Breite b der Hilfsstrukturen(15) in dem Bereich $\lambda/(10\ NA) < b < \lambda/(3\ NA)$ liegt.

5. Photolithographische Maske nach einem der vorhergehenden Ansprüche,
   **dadurch gekennzeichnet, daß**
   der Abstand D der Hauptstrukturen (13, 14, 20, 21, 22) in dem Bereich $\lambda/(2\ NA) < D < 3\ \lambda/NA$ liegt.

**6.** Photolithographische Maske nach einem der vorhergehenden Ansprüche, **dadurch gekennzeichnet, daß** der Abstand x der Hilfsstrukturen (15, 25) von den Hauptstrukturen in dem Bereich $\lambda/(5\,NA) < x < 2\,\lambda/(3\,NA)$ liegt.

**7.** Photolithographische Maske nach einem der vorhergehenden Ansprüche, **dadurch gekennzeichnet, daß** der Abstand d der Hilfsstrukturen (15, 25) im Bereich $\lambda/(3\,NA) < d < 3\,\lambda/(2\,NA)$ liegt.

**8.** Photolithographische Maske nach einem der vorhergehenden Ansprüche, **dadurch gekennzeichnet, daß** zu einer Hauptstruktur (13, 14, 20, 21, 22), die zumindest im Bereich eines Teilstücks in eine erste Richtung ausgerichtet ist, zumindest vier Hilfsstrukturen (15, 25) vorgesehen sind, die benachbart zum dem Teilstück in eine zweite Richtung im wesentlichen senkrecht zu der ersten Richtung ausgerichtet sind.

## Claims

**1.** Photolithographic mask for the exposure of radiation-sensitive resist layers on semiconductor substrates, the mask

- having at least one radiation-transmissive substrate and at least one half-tone layer, wherein the half-tone layer is a layer which is to a certain percentage radiation-transmitting and which shifts the phase of the radiation passing through it by a predetermined amount,
- the half-tone layer being used to provide main features (12, 13, 14, 20, 21, 22), the ratio of length to width of the main features (12, 13, 14, 20, 21, 22) being greater than 3, and the main features (12, 13, 14, 20, 21, 22) being formed in such a way that the pattern formed by the main features (12, 13, 14, 20, 21, 22) is transferred into the resist layer when irradiated, and
- the half-tone layer being used to provide assist features (15, 16, 25, 26), the assist features (15, 16, 25, 26) being formed in such a way that the pattern formed by the assist features (15, 16, 25, 26) is not transferred into the resist layer when irradiated, between two directly adjacent main features (13, 14, 20, 21, 22), which at least in the region of a partial piece are oriented substantially parallel in a first direction, there being at least two assist features (15, 25), which are oriented in a second direction substantially perpendicular to the first direction.

**2.** Photolithographic mask according to Claim 1, **characterized in that** the assist features (15, 25) are rectangular in shape.

**3.** Photolithographic mask according to Claim 1, **characterized in that** the assist features (15) are composed of triangular shapes.

**4.** Photolithographic mask according to one of the preceding claims, **characterized in that** the width b of the assist features (15) lies in the range $\lambda/(10\,NA) < b < \lambda/(3\,NA)$.

**5.** Photolithographic mask according to one of the preceding claims, **characterized in that** the distance D between the main features (13, 14, 20, 21, 22) lies in the range $\lambda/(2\,NA) < D < 3\,\lambda/NA$.

**6.** Photolithographic mask according to one of the preceding claims, **characterized in that** the distance x of the assist features (15, 25) from the main features lies in the range $\lambda/(5\,NA) < x < 2\,\lambda/(3\,NA)$.

**7.** Photolithographic mask according to one of the preceding claims, **characterized in that** the distance d between the assist features (15, 25) lies in the range $\lambda(3\,NA) < d < 3\,\lambda/(2\,NA)$.

**8.** Photolithographic mask according to one of the preceding claims, **characterized in that** for one main feature (13, 14, 20, 21, 22), which is oriented in a first direction at least in the region of a partial piece, there are at least four assist features (15, 25), which, adjacent to the partial piece, are oriented in a second direction substantially perpendicular to the first direction.

## Revendications

**1.** Masque photolithographique pour l'exposition de couches de réserve sensibles au rayonnement sur des substrats semiconducteurs, dans lequel le masque

- comporte au moins un substrat perméable au rayonnement et au moins une couche en demi-teinte, la couche en demi-teinte étant une couche perméable au rayonnement jusqu'à un certain pourcentage, qui décale d'un montant prescrit la phase du rayonnement la traversant,
- au moyen de la couche en demi-teinte, il est prévu des structures (12, 13, 14, 20, 21, 22) principales, le rapport de la longueur à la largeur des structures (12, 13, 14, 20, 21, 22) principales étant plus grand que 3, et les structures (12, 13, 14, 20, 21, 22) principales étant constituées de manière à ce que le modèle formé par les structures (12, 13, 14, 20, 21, 22) principales soit transmis à la couche de réserve lors d'une exposition, et

- au moyen de la couche en demi-teinte, il est prévu des structures (15, 16, 25, 26) auxiliaires, les structures (15, 16, 25, 26) auxiliaires étant constituées de façon à ce que le modèle formé par les structures (15, 16, 25, 26) auxiliaires ne soient pas transmis à la couche de réserve lors d'une exposition,

dans lequel, entre deux structures (13, 14, 20, 21, 22) principales voisines directement qui sont orientées au moins dans la zone d'une pièce partielle sensiblement parallèlement à une première direction, il est prévu au moins deux structures (15, 25) auxiliaires qui sont orientées dans une deuxième direction sensiblement perpendiculaire à la première direction.

2. Masque photolithographique suivant la revendication 1, **caractérisé en ce que** les structures (15, 25) auxiliaires ont une forme rectangulaire.

3. Masque photolithographique suivant la revendication 1, **caractérisé en ce que** les structures (15) auxiliaires sont constituées de formes triangulaires.

4. Masque photolithographique suivant l'une des revendications précédentes, **caractérisé en ce que** la largeur b des structures (15) auxiliaires est dans la plage $\lambda/(10\ NA) < b < \lambda/(3\ NA)$.

5. Masque photolithographique suivant l'une des revendications précédentes, **caractérisé en ce que** la distance D entre les structures (13, 14, 20, 21, 22) principales est dans la plage $\lambda/(2\ NA) < D < 3\ \lambda/NA$.

6. Masque photolithographique suivant l'une des revendications précédentes, **caractérisé en ce que** la distance x des structures (15, 25) auxiliaires aux structures principales est dans la plage $\lambda/(5\ NA) < x < 2\ \lambda/(3\ NA)$.

7. Masque photolithographique suivant l'une des revendications précédentes, **caractérisé en ce que** la distance d entre les structures (15, 25) auxiliaires est dans la plage $\lambda/(35\ NA) < d < 3\ \lambda/(2\ NA)$.

8. Masque photolithographique suivant l'une des revendications précédentes, **caractérisé en ce que** par rapport à une structure (12, 14, 20, 21, 22) principale qui est orientée au moins dans une zone d'une pièce partielle dans une première direction, il est prévu au moins quatre structures (15, 25) auxiliaires, qui, au voisinage de la pièce partielle, sont orientées dans une deuxième direction sensiblement perpendiculaire à la première direction.

# FIG 1

# FIG 2

# FIG 3

## FIG 4

20    21    22

## FIG 5

EP 1 421 445 B1

FIG 6

26  20  26   26  21  26   26  22  26

FIG 7

12

## FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5242770 A
- US 5821014 A
- EP 0770926 A